Europäisches Patentamt

European Patent Office

Office européen des brevets

(19)

(11) Publication number: **0 060 682**
**A2**

# (12) EUROPEAN PATENT APPLICATION

(21) Application number: **82301230.7**

(22) Date of filing: **11.03.82**

(51) Int. Cl.³: **H 05 K 3/00, H 05 K 1/02, H 01 L 27/01**

(30) Priority: **12.03.81 US 243176**

(43) Date of publication of application: **22.09.82**
**Bulletin 82/38**

(84) Designated Contracting States: **DE FR GB IT**

(71) Applicant: **HONEYWELL INC., Honeywell Plaza, Minneapolis Minnesota 55408 (US)**

(72) Inventor: **Cummings, John P., 11357 Harrison Road, Bloomington Minnesota 55437 (US)**
Inventor: **Pitkanen, David E., 2601 Xylon Avenue South, St. Louis Park Minnesota 55426 (US)**
Inventor: **Makos, Janice D., 4887 - 149th Court, Apple Valley Minnesota 55124 (US)**

(74) Representative: **Riddle, John et al, Honeywell Control Systems Ltd. Patent Department Charles Square, Bracknell, Berks. (GB)**

(54) **Process for making dielectric stencilled microcircuits.**

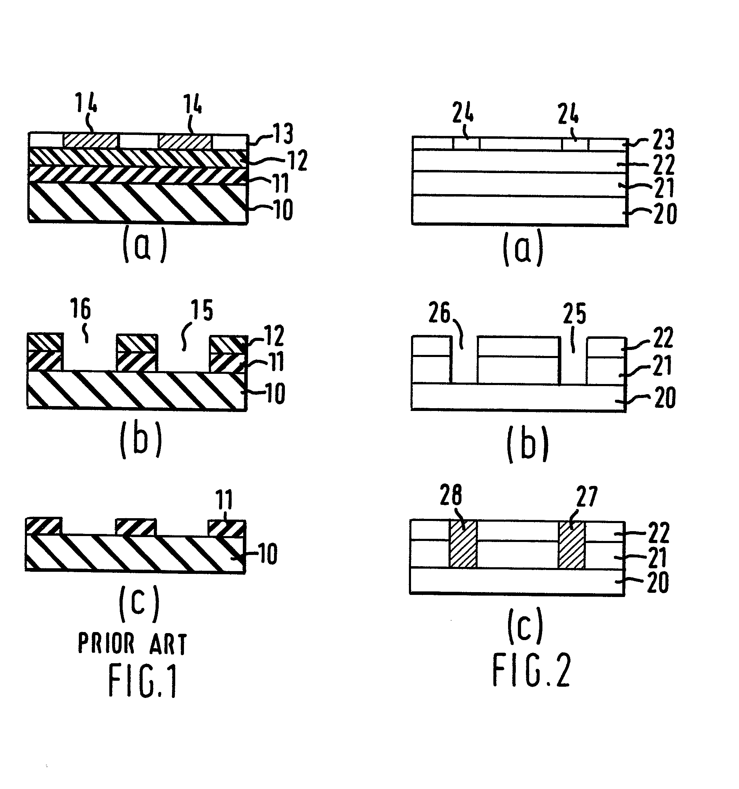

(57)     A process for making complex, high density microcircuits in which thick-film dielectric pastes (21) are photolithography patterned into high resolution stencils to produce complementary conductor circuitry patterns, the voids (25, 26 Figure 2b) of the developed dielectric stencil are filled with thick-film conductor paste (27, 28 Figure 2c) and then the resulting structure is fired in an air or nitrogen atmosphere. Thus the number of separate firing operations is reduced which is important in multilevel hybrid structures.

(a)

(b)

(c)

- 1 -

## PROCESS FOR MAKING DIELECTRIC STENCILED MICROCIRCUITS

### Background of the Invention

This invention relates to a process for making dielectric stenciled microcircuits. In U.S. Patent No. 4119480, there is described a process in which an insulating paste is coated onto a ceramic substrate and then dried to evaporate the thinners. A photosensitive region is next deposited on the insulating layer and dried, and a patterned lithographic mask placed over the dried resin.. The resulting structure is then exposed to UV light, developed to create voids in the insulating layer and finally fired.

According to the present invention, there is provided a process for fabricating dielectric stenciled microcircuits, the process comprising the steps of coating an insulating dielectric paste and photopatterning means over the surface of a substrate; selectively exposing through a photolithography mask the substrate coating to light; and removing the exposed dielectric paste in the areas where the conductive circuit lines are to be located, thereby forming a dielectric stencil with voids; characterized by the steps of filling the dielectric stencil voids with thick-film conductive paste to form the conductive lines; and, firing the resulting structure.

An embodiment of the invention will now be described, by way of example only, with reference to the accompanying drawings, in which:-

Figure 1 shows the steps in a prior art process,

Figures 2, a, b and c is a diagrammatic presentation of a process according to the invention, and

Figures 3, 4 and 5 are composite progressive pictorial views of a number of process steps of the present invention.

Technology advances made by the development of very large scale integrated (VLSI) electronic components have created a need for complex, high density interconnection circuitry for both chip carriers and multilayer hybrid micropackages. Screen printing can no longer meet the fine line (2 to 4 mil) resolution pattern requirements and therefore new methods of photopatterning thick film pastes are being developed making possible the required high density packaging.

In a prior art process described in U.S. Patent No. 4119480 a microcircuit making process (see Figure 1) includes the steps of coating an insulating paste 11 onto a ceramic substrate 10, drying the paste to evaporate the thinners, depositing a photosensitive resin 12 on the insulating layer, drying the layer 12, placing a patterned lighographic mask 13 over the layer 12, exposing with UV light through openings 14, developing and removing portions of the layers 11 and 12, and firing the assembly to provide the structure shown in Figure 1c.

There will now be described a process for producing high density thick-film hybrids by photolighography patterning of dried but unfired dielectric layers into high resolution stencils to produce complementary conductor circuitry patterns with a minimum of firing steps.

Referring now to Figure 2 there is shown a substrate 20, such as ceramic, having deposited thereon a dielectric thick-film paste 21. Examples of dielectric pastes which have been used are DuPont's 4175 dielectric and DuPont's 4275 dielectric which form dense dielectrics. The dielectric layer 21 is deposited and dried at room temperature. Over the dried dielectric layer 21 is deposited a polymer photoresist layer 22. After the photoresist layer had dried it is ready to be exposed to ultraviolet (UV) light through a suitable photolithography mask 23. In Figure 2a the mask is shown as having openings 24 which correspond to the fine line circuits it is desired to fabricate. Although the steps of depositing and drying the dielectric and depositing and drying photoresist have been described as separate steps, if a suitable insulating dielectric paste containing a photosensitve vehicle becomes available, these two steps may be combined into a single step. The fine line circuits may be on the order of 2 to 4 mils wide. Following the exposure to UV light, the photoresist layer 22 is treated with a developing solution for that type of photoresist. The solution is chosen for the simultaneous etching of the dielectric layer 21, as is shown in Figure 2b to form the voids 25 and 26 of the dielectric stencil. The voids are then filled, as shown in Figure 2c, with either an air-fireable noble metal conductor paste or nitrogen-fireable non-noble metal paste such as copper conductive paste 27 and 28 which becomes the thick film conductors. A firing of the resulting structure is then accomplished at the temperature range of $800^{\circ}C$ to $1000^{\circ}C$ in an air or nitrogen atmosphere in a suitable conveyor furnace to form both the dielectric level and the conductor lines or vias.

The process just described improves pattern resolution and performance properties of high-density thick-film circuits. It decreases the number of processing steps and high temperature firings. It also reduces hybrid multilayer circuit cost by eliminating patterning of conductors, by removing only dielectric film, by permitting cofiring of dielectric and conductor and the process is suitable for noble or base metal conductor materials.

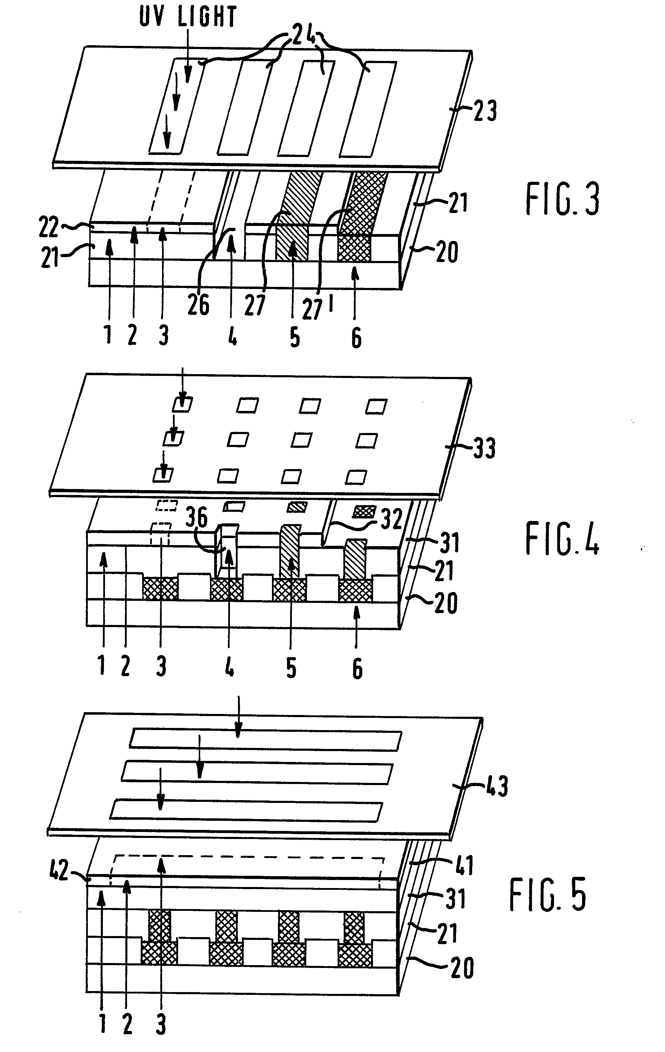

Figures 3, 4 and 5 are pictorial views of the processing steps described above in connection with Figure 2 for the process of fabricating or making the multilayer fine line circuit. The same identifying numerals are used in Figure 3 as in Figure 2 where practical, and the single digit numerals in Figure 3 relate to the processing steps enumerated in the paragraph above. Thus the numeral 1 depicts the processing step of depositing the layer 21 of thick-film dielectric paste. The numeral 2 depicts the processing step of depositing the layer 22 of photoresist. The numeral 3 depicts the step of exposing with UV light through the openings 24 of the photolithography mask 23. The numeral 4 depicts the processing step of developing the pattern whereby the photoresist material and the dielectric are removed to form the voids 25 and 26 of the dielectric stencil. These voids when filled with conductive paste become the $\underline{x}$-conductor lines 27 and 28 depicted by numeral 5. Numeral 6 depicts the cofiring of the conductive paste and the dielectric paste. During this firing all the organic resins are pyrolyzed and decomposed. Figure 4 is similar to Figure 3 but also shows the second dielectric layer 31 containing the vias 36 formed with mask 33 for interconnecting the different layers of conductive lines. The process steps are the same as for Figure 4. Figure 5 is similar to Figures 3 and 4 but in addition adds the third dielectric layer 41 which contains the $\underline{y}$-conductor lines. The process steps are the same as for Figure 3.

With the above described process the number of separate firing operations is reduced. The reduction in the number of firings is important in multilevel hybrid structures because material interactions are reduced since they are related to the number of firings. Registration is maintained since it too is a function of number of firings. The dielectric stencil approach minimizes the conductor paste rheology contraints because the conductor paste is contained in the dielectric voids.

CLAIMS

1. A process for fabricating dielectric stenciled microcircuits, the process comprising the steps of coating an insulating dielectric paste and photopatterning means over the surface of a substrate; selectively exposing through a photolithography mask the substrate coating to light; and removing the exposed dielectric paste in the areas where the conductive circuit lines are to be located, thereby forming a dielectric stencil with voids; characterized by the steps of filling the dielectric stencil voids with thick-film conductive paste to form the conductive lines; and, firing the resulting structure.

2. The process according to Claim 1, characterized in that the firing step takes place in a nitrogen atmosphere at a temperature range of $800^{\circ}C$ to $1000^{\circ}C$.

3. The process according to Claim 1, characterized in that the firing step takes place in an air atmosphere at a temperature range of $800^{\circ}C$ to $1000^{\circ}C$.

4. The process according to Claim 1, 2 or 3, characterized in that the thick-film conductive paste is a noble metal, or a base metal such as copper.

5. The process according to any one of the preceding claims, characterized in that the photopatterning means of the coating is a constituent of the dielectric paste.

6. The process according to any one of Claims 1 to 4, characterized in that the photopatterning means of the coating is a layer of photoresist deposited over the dielectric paste.

7. The process of any one of the preceding claims, characterized in that the coating step includes depositing a layer of an insulating dielectric paste over the surface of the substrate and drying the dielectric paste layer, and depositing a layer of photoresist over the insulating dielectric paste and drying the photoresist layer.

8. A microcircuit made by the process according to any one of Claims 1 to 7.

(a)

(b)

(c)

PRIOR ART

FIG.1

(a)

(b)

(c)

FIG.2

0060682

UV LIGHT

24

23

22
21

26  27  27¹

1  2  3    4    5    6

FIG.3

33

36            32

31
21
20

1 2  3    4    5    6

FIG.4

43

42            41

31
21
20

1  2  3

FIG.5